Europäisches Patentamt

European Patent Office

Office européen des brevets

(19)

(11) **EP 0 484 921 B1**

(12) **EUROPEAN PATENT SPECIFICATION**

(45) Date of publication and mention
of the grant of the patent:
**13.08.1997 Bulletin 1997/33**

(51) Int Cl.⁶: **H03K 5/08**

(21) Application number: **91118933.0**

(22) Date of filing: **06.11.1991**

(54) **Differential circuit for converting a single phase signal into complementary signals**

Differentialschaltung zur Umsetzung eines Einphasen-Signals in ein Komplementärsignal

Circuit différentiel de conversion d'un signal monophasé en des signaux complémentaires

(84) Designated Contracting States:
**DE FR GB**

(30) Priority: **06.11.1990 JP 300052/90**

(43) Date of publication of application:
**13.05.1992 Bulletin 1992/20**

(73) Proprietor: **NEC CORPORATION
Tokyo (JP)**

(72) Inventor: **Asazawa, Hiroshi, c/o NEC Corporation
Minato-ku, Tokyo (JP)**

(74) Representative: **Glawe, Delfs, Moll & Partner
Patentanwälte
Postfach 26 01 62
80058 München (DE)**

(56) References cited:
**US-A- 4 943 736**

• **PATENT ABSTRACTS OF JAPAN vol. 7, no. 251
(E-209)(1396) 8 November 1983 & JP-A- 58 138
121**
• **IEEE TRANSACTIONS ON CIRCUITS AND
SYSTEMS. vol. 31, no. 1, 31 January 1984, NEW
YORK US pages 49 - 63; HUNG CHANG LIN:
'Integerated Circuit techniques'**
• **PATENT ABSTRACTS OF JAPAN vol. 6, no. 136
(E-120)(1014) 23 July 1982 & JP-A-57 061 330**

## Description

### FIELD OF THE INVENTION

This invention relates to a differential circuit and, more particularly, to a differential circuit for converting a single phase input signal into complementary output signals.

### DESCRIPTION OF THE RELATED ART

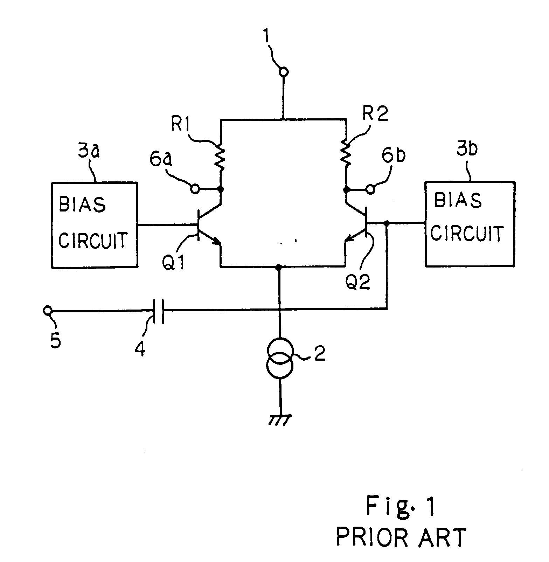

A typical example of the differential circuit is illustrated in Fig. 1, and comprises two series combinations of resistors R1 and R2 and n-p-n bipolar transistors Q1 and Q2 coupled in parallel between a source of power voltage level 1 and a constant current source 2, bias circuits 3a and 3b coupled with the base nodes of the n-p-n bipolar transistors Q1 and Q2, and an input capacitor 4 coupled between an input node 5 and the base node of the n-p-n bipolar transistor Q2. The constant current source 2 is grounded, and the collector nodes of the n-p-n bipolar transistors Q1 and Q2 are coupled with a pair of output nodes 6a and 6b. A single phase input signal is applied to the input node 5, and the input capacitor eliminates direct-current component from the single phase input signal. The alternate-current is supplied from the input capacitor 4 to the base node of the n-p-n bipolar transistor Q2, and causes the n-p-n bipolar transistor to change the collector current. Since the total current passing through the n-p-n bipolar transistors Q1 and Q2 is constant, the collector currents of the n-p-n bipolar transistors Q1 and Q2 are complementarily changed with the alternate-current, and a complementary output signal is produced between the output nodes 6a and 6b.

A problem is encountered in the prior art differential circuit in that the input capacitor 4 is hardly integrated on a semiconductor chip. This is because of the fact that the input capacitor 4 is too large to fabricated on the semiconductor chip. Namely, the capacitance of the input capacitor 4 is expected to be large enough to cut off the direct-current component of the single phase input signal at a certain frequency, and the single phase input signal at a relatively high frequency increases the capacitance and, accordingly, the occupation area on the semiconductor chip. It is not desirable to enlarge the semiconductor chip, and, for this reason, the input capacitor 4 is liable to be left out of the semiconductor chip. In other words, the prior art differential circuit consists of an integrated circuit fabricated on the semiconductor chip except for the input capacitor 4 and a discrete capacitor.

US-A-4,943,736 shows a waveform converting apparatus including a first and a second common-emitter type transistor as part of a first and second emitter follower circuit. The follower circuits are used for converting the impedance of an input signal independently.

From Patent Abstract of Japan, vol. 7, No. 251 (E-209) [1396] for JP-A-58 138 121 a waveform shaping circuit is known in which a DC voltage of a voltage signal is changed, a level difference is changed by change of a constant current source through the effect of the DC voltage change.

### SUMMARY OF THE INVENTION

It is therefore an important object of the present invention to provide a differential circuit the circuit components of which are integrated on a single semiconductor chip.

To accomplish these objects, the present invention proposes to replace the input capacitor with a combination of a level shifter and a low-pass filter.

The object of the invention is solved by the features of claim 1.

### BRIEF DESCRIPTION OF THE DRAWINGS

The features and advantages of the differential circuit according to the present invention will be more clearly understood from the following description taken in conjunction with the accompanying drawings in which:

Fig. 1 is a circuit diagram showing the arrangement of the prior art differential circuit;
Fig. 2 is a circuit diagram showing the arrangement of a differential circuit according to the present invention;
Fig. 3 is a graph showing voltage levels at essential nodes of the differential circuit in terms of time; and
Fig. 4 is a graph showing voltage levels at the essential nodes in terms of time at different conditions from those of Fig. 3.

### DESCRIPTION OF THE PREFERRED EMBODIMENT

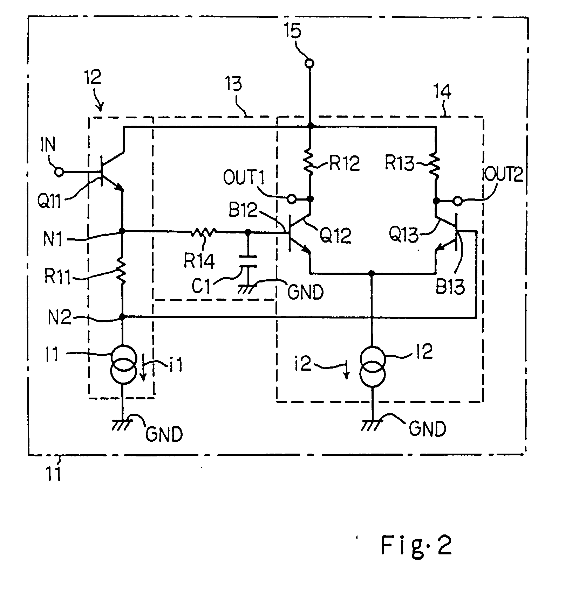

Referring to Fig. 2 of the drawings, a differential circuit embodying the present invention is fabricated on a single semiconductor chip 11, and largely comprises a level shifting section 12 implemented by an emitter follower, a low-pass filter section 13 and a differential section 14. The level shifting section 12 has a series combination of an n-p-n bipolar transistor Q11, a first intermediate node N1, a resistor R11, a second intermediate node N2 and a current source I1 coupled between a source of power voltage level 15 and a ground node GND, and a signal phase input signal is supplied from an input node IN to the base node of the n-p-n bipolar transistor Q11. The constant current source I1 allows current i1 to constantly flow therethrough, and the resistor R11 provides resistance r11.

The differential section 14 has two series combinations of resistors R12 and R13 and n-p-n bipolar transistors Q12 and Q13 coupled in parallel between the source of power voltage level and a constant current source I2, and the constant current source I2 in turn is coupled with the ground node GND. The constant current source I2 allows current i2 to constantly pass therethrough, and the base node B13 of the n-p-n bipolar transistor Q13 is coupled with the second intermediate node N2. The n-p-n bipolar transistors Q12 and Q13 has a direct-current amplification factor beta. The collector nodes of the n-p-n bipolar transistors Q12 and Q13 are respectively coupled with output nodes OUT1 and OUT2, and a complementary output signal takes place between the output nodes OUT1 and OUT2.

The low pass filter section 13 has a resistor R14 coupled between the first intermediate node N1 and the base node B12 of the n-p-n bipolar transistor Q12, and a capacitor C1 coupled between the base node B12 of the n-p-n bipolar transistor Q12 and the ground node GND. The resistor R14 and the capacitor C1 respectively provide resistance r14 and capacitance c1 which are regulated to eliminate alternate-current component from the signal phase input signal.

The circuit parameters of the level shifting section 12 and the low pass filter section 13 are regulated in such a manner that the voltage levels at the base nodes B12 and B13 of the n-p-n bipolar transistors Q12 and Q13 are balanced with each other for direct-current component of the single phase input signal. In detail, assuming now that voltage level V0 takes place at the emitter node of the n-p-n bipolar transistor Q11 due to direct-current component of the signal phase input signal, voltage level V13 at the base node B13 of the n-p-n bipolar transistor Q13 is calculated as

$$V13 = V0 - r11 \times i1 \qquad \text{Equation 1}$$

While the n-p-n bipolar transistor Q13 is balanced with the n-p-n bipolar transistor Q12, each of the collector currents Ic12 and Ic13 is expressed as

$$Ic12 \text{ or } Ic13 = i2 / 2 \qquad \text{Equation 2}$$

Each of the base currents Ib12 and Ib13 is given as

$$Ib12 \text{ or } Ib13 = i2 / (2 \times beta) \qquad \text{Equation 3}$$

Voltage level V12 at the base node B12 of the n-p-n bipolar transistor Q12 is given as

$$V12 = V0 - r14 \times i2 / (2 \times beta) \qquad \text{Equation 4}$$

From Equations 1 and 4, in order to balance the voltage level V13 with the voltage level V12, the resistances r13 and r14 need to be regulated as

$$r14 = (2 \times i1 \times r11 \times (beta)) / i2 \qquad \text{Equation 5}$$

If the circuit parameters are regulated as described hereinbefore, the voltage levels at the base nodes B12 and B13 of the n-p-n bipolar transistors Q12 and Q13 are balanced with each other due to the direct-current component of the signal phase input signal, and the alternate-current component is applied to the base node B13 of the n-p-n bipolar transistor Q13 only. In other words, the complementary output signal is proportionally varied with the single phase input signal.

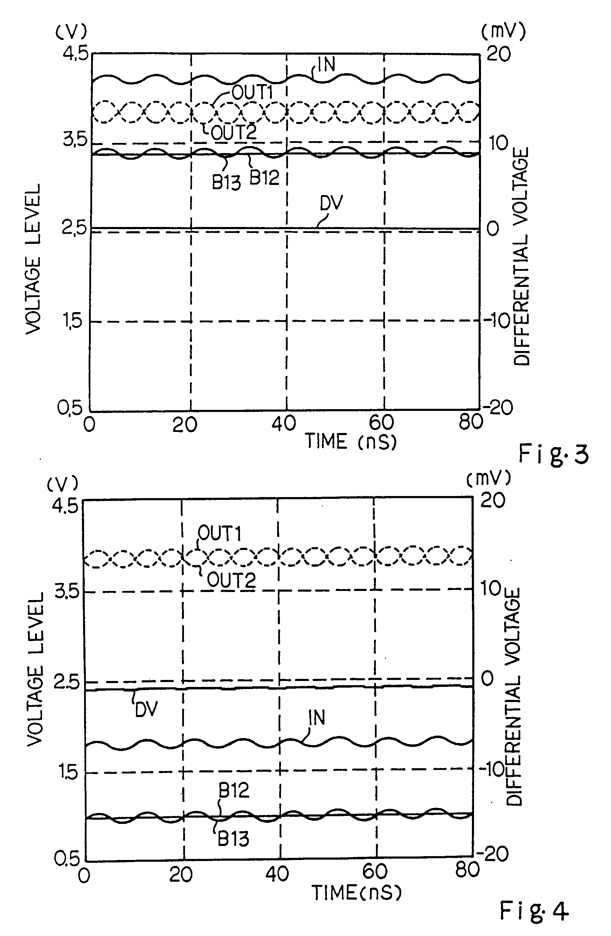

Figs. 3 and 4 show voltage levels in terms of time obtained through a computer simulation for the differential circuit shown in Fig. 2. In the computer simulation, the direct-current amplification factor beta is 100, the resistance r11 is 100 ohms, each of the currents i1 and i2 is 100 microamperes, the capacitance c1 is 20 picofarad, and the resistance r14 is 20 kilo-ohm given from Equation 5.

For the computer simulation shown in Fig. 3, the power voltage level is 4 volts, and the direct-current component of the signal phase input signal is 4.2 volts. The signal phase input signal contains the alternate-current component with amplitude of 100 millivolt at 100 MHz. Plots are labeled with the same references as the nodes of the differential circuit and the voltage levels in the above equations, and plots DV stand for the differential voltage level between the direct-components of the voltage levels at the base nodes B12 and B13. As will be understood from Fig. 3, the voltage level at the base node B13 is proportionally produced from the single phase input signal at different level by means of the level shifting section 12, and the low pass filter section 13 effectively eliminates the alternate-current component from the single phase input signal. Namely, the voltage level at the center of the amplitude is effectively extracted by the low pass filter section 13, and is effectively applied to the base node B12 of the n-p-n bipolar transistor Q12. Plots DV do not exceed 1 millivolt, and confirm that Equation 5 exactly expresses the relation between the circuits parameters between the level shifting section 12 and the low pass filter section 13. The n-p-n bipolar transistors Q12 and Q13 produce the complementary output signal from the voltage levels at the base nodes B12 and B13.

For the computer simulation shown in Fig. 4, the direct-current component of the signal phase input signal is changed to 1.8 volts. However, the voltage level at the base node B13 follows the single phase input signal, and the low pass filter section 13 effectively eliminates the alternate-current component from the single phase input signal, and the complementary output signal is similar to that of Fig. 3. Therefore, Figs. 3 and 4 bring reliable evidences as a proof of the advantages of the present invention. In fact, the difference circuit according to the present invention is responsive to the single phase input signal regardless of the magnitude of the direct-current component in so far as the following conditions are satisfied. Namely, the voltage level due to the direct-current component does not saturate the emitter-base voltage Vbe of the n-p-n bipolar transistor Q11, and does not saturate the constant current source I2 due to the darlington amplifier of the n-p-n bipolar transistors Q11 and Q12.

As will be appreciated from the foregoing description, the differential circuit according to the present invention can be fabricated on a single semiconductor chip by virtue of the combination of the level shifting section and the low pass filter section. In fact, if the single phase input signal is 100 MHz, the prior art differential circuit occupies about $3 \times 10^5$ square-micron, however, the differential circuit shown in Fig. 2 merely consumes $2 \times 10^4$ square-micron.

Although particular embodiments of the present invention have been shown and described, it will be obvious to those skilled in the art that various changes and modifications may be made without departing from the scope of the present invention as defined in the Claim. For example, the differential circuit may form a part of an integrated circuit fabricated on a single semiconductor chip, or may be fabricated on a single chip semiconductor chip alone.

**Claims**

1. A differential circuit fabricated on a single semiconductor chip (11), comprising:

   a) a differential section (14) having first and second series combinations of first and second resistors (R13/R12) and first and second bipolar transistors (Q13/Q12) coupled in parallel between a first source of voltage level (15) and a common emitter node, and a first constant current source (I2) coupled between said common emitter node and a second source of voltage level (GND) different in voltage level from said first source of voltage level (15);
   b) a pair of output nodes (OUT1/OUT2) respectively coupled with collector nodes of said first and second bipolar transistors, and supplied with a complementary output signal therefrom;
   c) a level shifting section (12) including a series combination of a third bipolar transistor (Q11) having a base node coupled with an input node (IN) and controlled by a single phase input signal, a first intermediate node (N1), a third resistor (R11), a second intermediate node (N2) coupled with a base node (B13) of said first bipolar transistor and a second constant current source (I1) coupled between said first and second sources of voltage level; and
   d) a low pass filter section (13) including a fourth resistor (R14) coupled between said first intermediate node and a base node (B12) of said second bipolar transistor and a capacitor (C1) coupled between the base node of said second bipolar transistor and said second source of voltage level, and eliminating an alternate-current component of said signal phase input signal, circuit parameters of said level shifting section and said low pass filter section being regulated in such a manner as to balance the voltage levels at the base nodes of said first and second bipolar transistors for direct-current component of said single phase input signal,

**characterized in that**
the resistance R2 (r14) of said fourth resistor is expressed as

$$R2 = (2 \times I2 \times AF \times R1) / I1$$

where I2 is a current (i1) passing through said second constant current source, AF is the direct-current amplification factor of each of said first and second bipolar transistors, R1 is the resistance (r11) of said third resistor, and I1 is a current (i2) passing through the first constant current source.

**Patentansprüche**

1. Differentialschaltung, die auf einem einzigen Halbleiterchip (11) hergestellt ist, mit:

   a) einem Differentialabschnitt (14) mit ersten und zweiten Reihenkombinationen aus ersten und zweiten Widerständen (R13/R12) und ersten und zweiten Bipolartransistoren (Q13/Q12), die zwischen einer ersten Quelle vom Spannungspegel (15) und einem gemeinsamen Emitterknoten parallel gekoppelt sind, und einer ersten Konstantstromquelle (I2), die zwischen dem gemeinsamen Emitterknoten und einer zweiten Quelle vom Spannungspegel (GND), der sich vom Spannungspegel von dem der ersten Spannungpegelquelle (15) unterscheidet, gekoppelt ist;
   b) einem Paar Ausgangsknoten (OUT1/OUT2), die jeweils mit Kollektorknoten der ersten und zweiten Bipolartransistoren gekoppelt sind und mit einem komplementären Ausgangssignal derselben gespeist werden;
   c) einem Pegelschiebeabschnitt (12) mit einer Reihenkombination aus einem dritten Bipolar-Transistor (Q11), der mit seinem Basisknoten an einen Eingangsknoten (IN) gekoppelt ist und durch ein Einphasen-Eingangssignal gesteuert wird, einem ersten Zwischenknoten (N1), einem dritten Widerstand (R11), einem zweiten Zwischenknoten (N2), der mit einem Basisknoten (B13) des ersten Bipolartransistors gekoppelt ist und einer zweiten Konstantstromquelle (I1), die zwischen die ersten und zweiten Spannungspegelquellen gekoppelt ist; und

d) einem Tiefpaßfilterabschnitt (13) mit einem vierten Widerstand (R14), der zwischen dem ersten Zwischenknoten und einem Basisknoten (B12) des zweiten Bipolartransistors gekoppelt ist, und einem Kondensator (C1), der zwischen dem Basisknoten des zweiten Bipolartransistors und der zweiten Spannungspegelquelle gekoppelt ist, und eine Wechselstromkomponente des Einphasen-Eingangssignals eliminiert, wobei Schaltungsparameter des Pegelschiebeabschnitts und des Tiefpaßfilterabschnitts so reguliert sind, daß sie die Spannungspegel an den Basisknoten der ersten und zweiten Bipolartransistoren für die Gleichstromkomponente des Einphaseneingangssignals ausgleichen;

dadurch **gekennzeichnet,** daß der Widerstandswert R2(r14) des vierten Widerstandes ausgedrückt wird durch:

$$R2 = (2 \times I2 \times AF \times R1)/I1$$

mit I2 gleich einem Strom (i1), der durch die zweite Konstantstromquelle durchgeht, AF gleich dem Gleichstrom-Verstärkungsfaktor jedes der ersten und zweiten Bipolartransistoren, R1 gleich dem Widerstand (r11) des dritten Widerstands und I1 gleich einem Strom (i2), der durch die erste Konstantstromquelle geht.

## Revendications

1. Circuit différentiel fabriqué sur une puce à semiconducteur unique (11), comportant :

a) un tronçon différentiel (14) ayant une première et une seconde combinaisons séries d'une première et d'une deuxième résistances (R13/R12) et d'un premier et d'un deuxième transistors bipolaires (Q13/Q12) reliées en parallèle entre une première source de niveau de tension (15) et un noeud d'émetteur commun, et une première source de courant constant (I2) reliée entre ledit noeud d'émetteur commun et une seconde source de niveau de tension (GND) différente en niveau de tension de ladite première source de niveau de tension (15)

b) une paire de noeuds de sortie (OUT1/OUT2) reliés respectivement au noeud de collecteur desdits premier et deuxième transistors bipolaires, et alimentés en signaux de sortie complémentaires à partir de ceux-ci,

c) un tronçon de changement de niveau (12) comportant une combinaison série d'un troisième transistor bipolaire (Q11) ayant un noeud de base relié à un noeud d'entrée (IN) et commandé par un signal d'entrée de base unique, un premier noeud intermédiaire (N1), une troisième résistance (R11), un second noeud intermédiaire (N2) relié à un noeud de base (B13) dudit premier transistor bipolaire et à une seconde source de courant constant (I1) reliée entre lesdites première et seconde sources de niveau de tension, et

d) un tronçon (13) de filtre passe-bas comportant une quatrième résistance (R14) reliée entre ledit premier noeud intermédiaire et un noeud de base (B12) dudit deuxième transistor bipolaire et un condensateur (C1) relié entre le noeud de base dudit deuxième transistor bipolaire et ladite seconde source de niveau de tension, et éliminant une composante alternative dudit signal d'entrée de phase unique, des paramètres de circuit dudit tronçon de changement de niveau et dudit tronçon de filtre passebas étant régulés de manière à équilibrer les niveaux de tension au niveau des noeuds de base desdits premier et deuxième transistors bipolaires pour la composante continue dudit signal d'entrée de phase unique,

caractérisé en ce que

la résistance R2 (r14) de ladite quatrième résistance est exprimée par :

$$R2 = (2 \times I2 \times AF \times R1) / I1$$

où I2 est un courant (i1) passant à travers ladite seconde source de courant constant, AF est le facteur d'amplification de courant continu de chacun desdits premier et deuxième transistors bipolaires, R1 est la résistance (r11) de ladite troisième résistance et I1 est un courant (i2) passant à travers la première source de courant constant.

Fig. 1
PRIOR ART

Fig.2

Fig. 3

Fig. 4